# EUROPEAN PATENT APPLICATION

(11) **EP 0 877 437 A1**
(43) Date of publication of application: **11.11.1998**
(21) Application number: 98108190.4
(22) Date of filing: 05.05.1998
(51) Int. Cl.: H01P 7/08

(54) **Strip-line resonator and variable resonator**

(30) Priority: 07.05.1997 JP 117252/97; 29.09.1997 JP 263802/97; 13.04.1998 JP 101151/98
(71) Applicant: MURATA MANUFACTURING CO., LTD., Nagaokakyo-shi Kyoto-fu 226 (JP)
(72) Inventor: Ishii, Takehito, Nagaokakyo-shi, Kyoto-fu (JP); Furutani, Koji, Nagaokakyo-shi, Kyoto-fu (JP); Tonegawa, Ken, Nagaokakyo-shi, Kyoto-fu (JP); Nakajima, Norio, Nagaokakyo-shi, Kyoto-fu (JP)
(74) Representative: Schoppe, Fritz, Dipl.-Ing.

(57) **Abstract**

A strip-line resonator (10) includes a lamination of a third dielectric layer (13c) having a transmission line conductor (11a) thereon and a via hole (12) in the direction of thickness, a fourth dielectric layer (13d) having a transmission line conductor (11b) thereon, a second and fifth dielectric layers (13b, 13e), each having a ground conductor (14) thereon, and a dielectric layer (13a) for protective purpose. The transmission line conductors (11a, 11b) respectively have a semi-spiral shape, face each other with the third dielectric layer (13c) interposed therebetween and are arranged in the direction of lamination such that both conductors are generally superimposed, and are electrically connected in series through the via hole (12) formed in the third dielectric layer (13c) so that the directions of travel of high-frequency signals propagating on both conductors are the same, and both conductors constitute a single transmission line (11). The ground conductors (14) are arranged on the top surfaces of the second and fifth dielectric layers (13b, 13e) such that they respectively cover most of the surfaces of the second and fifth dielectric layers (13b, 13e).

## Description

### BACKGROUND OF THE INVENTION

### 1. Field of the Invention

The present invention relates to a strip-line resonator and, more particularly, to a strip-line resonator formed by laminating a plurality of dielectric layers.

The present invention also relates to a variable resonator including the above strip-line resonator.

### 1. Related Art of the Invention

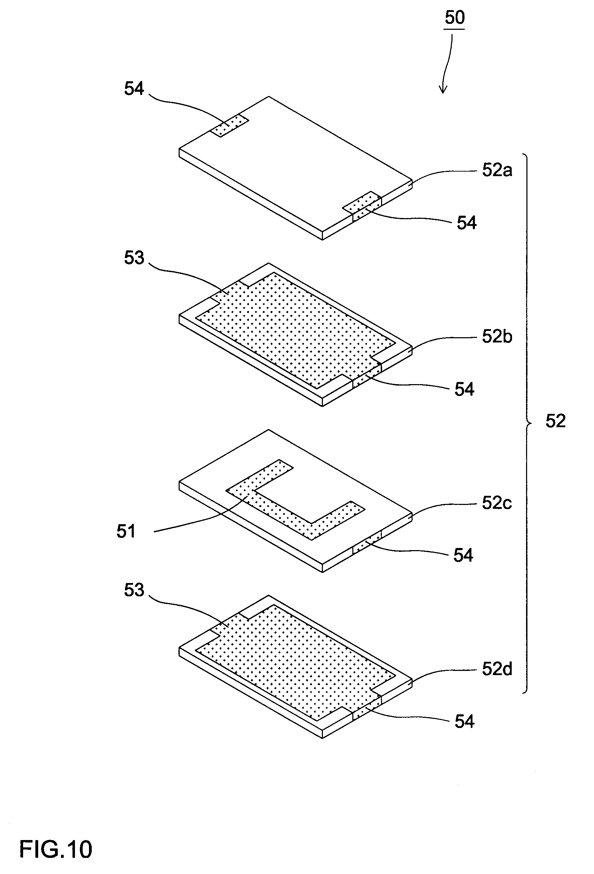

FIG. 10 is an exploded perspective view of a conventional strip-line resonator. The strip-line resonator 50 includes a laminated body 51 comprising a third dielectric layer 52c having a single transmission line 51 of a single transmission line conductor thereon, a second and fourth dielectric layers 52b, 52d having respectively a ground conductor 53, and a first protective dielectric layer 52a, and formed is a ground terminal 54 which runs from the top surface to the bottom surface of the laminated body 51 along its side surface of the laminated body 51 and is electrically connected to the ground conductors 53. The third dielectric layer 52c having the transmission line 51 thereon is interposed between the second and fourth dielectric layers 52b, 52d, each having the ground conductor 53. The strip-line resonator 50 includes the single transmission line 51 of a single layer having a predetermined characteristic impedance between the two ground conductors 53.

In the above described conventional strip-line resonator, since a single layer of transmission line is arranged between the two ground conductors in the conventional strip-line resonator, the length of transmission line per layer is long, making the strip-line resonator bulky.

Further, because of its strip-line structure, the strip-line resonator has the transmission line between the two ground conductors, and the effect of the stray capacity present between the transmission line and the ground electrodes lowers the characteristic impedance of the transmission line, thereby lowering Q factor.

### SUMMARY OF THE INVENTION

The present invention has been developed to overcome the above problem and to provide a compact strip-line resonator with a transmission line that heightens the characteristic impedance to a high impedance.
The present invention provides a strip-line resonator, comprising: a laminated body including a plurality of dielectric layers laminated to each other; a plurality of transmission line conductors disposed between said dielectric layers respectively, in which at least two of said transmission line conductors are substantially opposed to each other via said dielectric layer and electrically connected in series so that high-frequency signals traveling on said transmission line conductors travel in the same direction; and a ground conductor disposed between said dielectric layers, opposed to said transmission line conductor via said dielectric layer, and electrically disconnected to said transmission line conductor.

According to the strip-line resonator of the present invention, the transmission line includes a plurality of transmission line conductors, and the length of the transmission line conductor per layer is made shorter than in the conventional art, given that the characteristic impedance of the transmission line remains constant. As a result, a compact high-frequency component can be obtained.

Since the directions of travel of high-frequency signals propagating on two adjacent transmission line conductors with a dielectric layer placed therebetween are the same, the directions of flows of the magnetic fluxes generated circularly around the transmission line conductors are the same. Therefore, by narrowing the spacing between two adjacent transmission line conductors, the coupling between the transmission line conductors is increased, and a desired characteristic impedance is easily realized.

Even if the transmission line is disposed between the two ground electrodes in a strip-line structure to shield transmission line from external electromagnetic noise, a drop in characteristic impedance of the transmission line arising from the effect of stray capacity generated between the transmission line and the ground electrodes is compensated for, and a high characteristic impedance of the transmission line is provided. The Q factor of the strip-line resonator is heightened.

With the strip-line resonator of the present invention incorporated in a voltage-controlled oscillator, C/N of the voltage-controlled oscillator is improved.

The present invention further provides a variable resonator including the above described strip-line resonator, comprising: a substrate including said strip-line resonator; a variable capacitance diode mounted on said substrate; a passive component disposed within or mounted on the substrate; and an external terminal provided on the surface of the substrate.

Since in the variable resonator of the present invention, circuit components constituting the variable resonator are built into or mounted on a substrate which is a lamination of a plurality of dielectric layers, compact design is implemented in the variable resonator. As a result, the radio equipment incorporating the variable resonator is made compact accordingly.

By building the resonator, constituting the variable resonator, into the substrate that is a lamination of a plurality of dielectric layers, the resonator is of a monolithic structure supported by the insulating supports, and is thus electrically insulated from outside.

Other features and advantages of the present invention will become apparent from the following description of the invention which refers to the accompanying drawings.

### BRIEF DESCRIPTION OF THE DRAWINGS

FIG. 1 is an exploded perspective view of a first embodiment of the strip-line resonator of the present invention.

FIG. 2 is a cross-sectional view of the strip-line resonator of FIG. 1.

FIG. 3 is a Graph showing the resonance of the strip-line resonator of FIG. 1.

FIG. 4 is a schematic diagram of the voltage-controlled oscillator that incorporates the strip-line resonator of FIG. 1.

FIG. 5 is a schematic diagram of a second embodiment of the variable resonator of the present invention.

FIG. 6 is a perspective view of the variable resonator of FIG. 5.

FIGs. 7(a)∼7(f) are top views for the first ∼ sixth dielectric layers constituting the substrate of the variable resonator of FIG. 6.

FIGs. 8(a)∼8(d) are top views for the seventh ∼ tenth dielectric layers constituting the substrate of the variable resonator of FIG. 6 and FIG. 8(e) is a bottom view of the tenth dielectric layer of the substrate.

FIG. 9 is a schematic diagram of another embodiment of the variable resonator according to the present invention.

FIG. 11 is a schematic diagram of the voltage-controlled oscillator employing a conventional variable resonator.

FIG. 10 is an exploded perspective view showing one example of conventional strip-line resonator.

### PREFERRED EMBODIMENTS OF THE PRESENT INVENTION

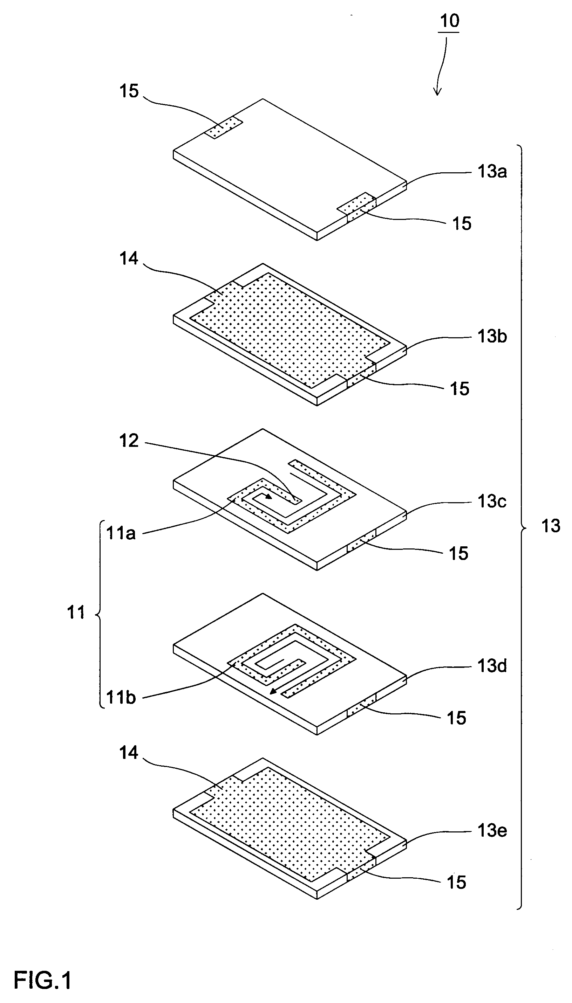

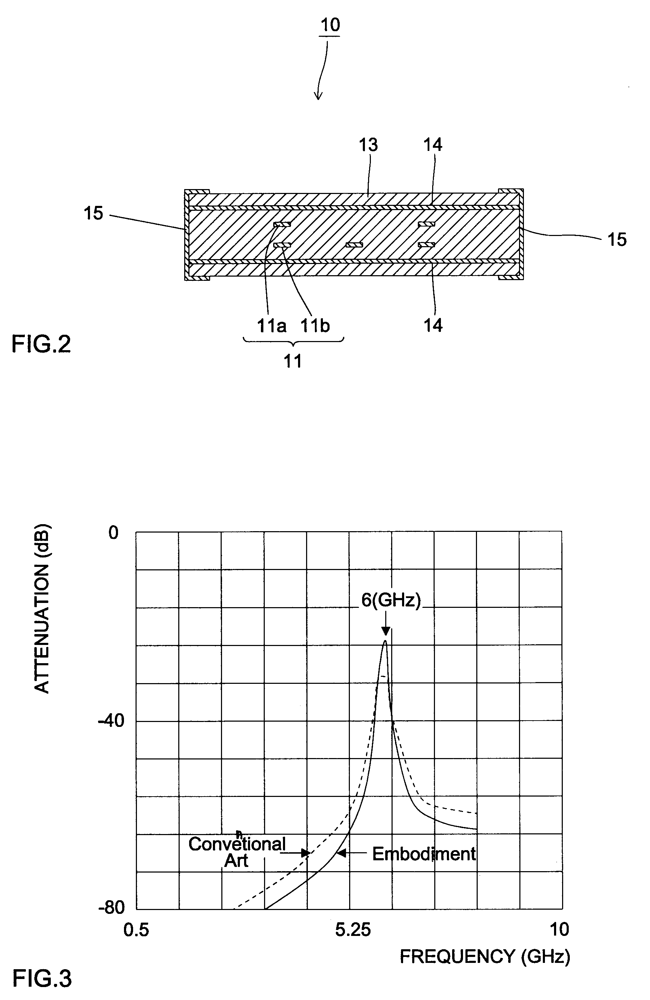

FIGS. 1 and 2 are exploded perspective view and cross-sectional view of a first embodiment of the strip-line resonator of the present invention. The strip-line resonator 10 includes a lamination of a third dielectric layer 13c having a transmission line conductor 11a thereon and a via hole 12 in the direction of thickness, a fourth dielectric layer 13d having a transmission line conductor 11b thereon, a second and fifth dielectric layers 13b, 13e, each having a ground conductor 14 thereon, and a dielectric layer 13a for protective purpose.

The transmission line conductors 11a, 11b respectively have a semi-spiral configuration, and face each other in the direction of lamination with the third dielectric layer 13a interposed therebetween such that both conductors are generally superimposed. Furthermore, the transmission line conductors 11a, 11b are electrically connected in series through the via hole 12 formed in the third dielectric layer 13c so that the directions of travel of high-frequency signals propagating on both conductors are the same, and both conductors constitute a single transmission line 11.

The ground conductors 14 are arranged on the surfaces of the second and fifth dielectric layers 13b, 13e such that they respectively cover most of the surfaces of the second and fifth dielectric layers 13b, 13e.

The transmission line conductors 11a, 11b and the ground conductors 14 are constructed of Ag, Pd, Ag-Pd, Cu or the like, and are formed on the surfaces of the second - fifth dielectric layers 13b - 13e using a known technique such as printing technique, sputtering technique, vacuum deposition technique. The first - fifth dielectric layers 13a - 13e is a sheet structure which is obtained by kneading a dielectric ceramic powder and a binder or the like.

The first - fifth dielectric layers 13a - 13e thus constructed are laminated and sintered into a unitary body as a laminated body 13. The ground terminal 15 electrically connected to the ground conductors 14 runs from the top surface to the bottom surface of the laminated body 13 along the side surface of the laminated body 13. The ground terminal 15 is formed using sputtering technique, vacuum deposition technique, baking technique or the like.

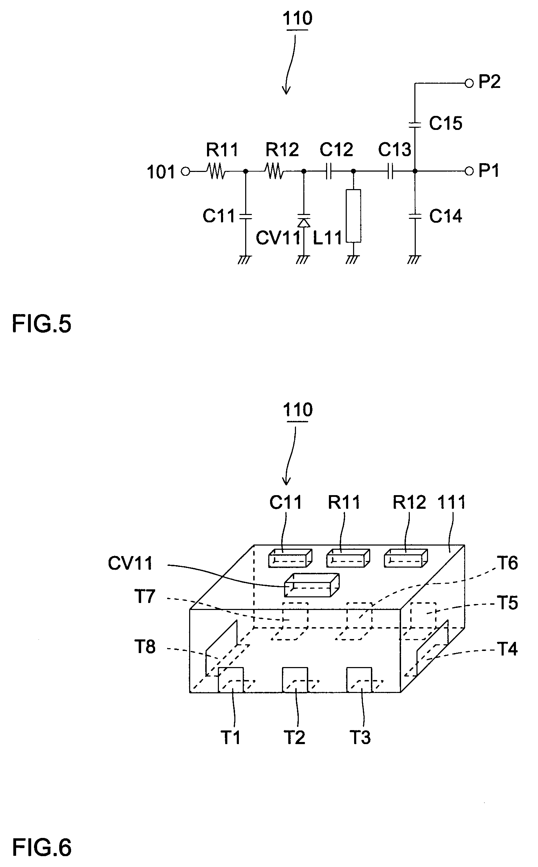

The strip-line resonator of the above embodiment comprises a single transmission line of two transmission line conductors between the two ground conductors, one top and one bottom, as shown in FIG. 2. Given a constant characteristic impedance, the length of the transmission line conductor per layer is approximately half that of the conventional art. As a result, compared with the conventional strip-line resonator (FIG. 5), the strip-line resonator of this embodiment assures the characteristic impedance of the transmission line to a predetermined value with its small-sized components, presenting a compact strip-line resonator.

Since the directions of travel of high-frequency signals propagating on the two adjacent transmission line conductors with a dielectric layer interposed therebetween are the same, the directions of flow of the magnetic fluxes generated circularly around the transmission line conductors are the same. The two adjacent transmission line conductors with a dielectric layer interposed therebetween are electromagnetically coupled by the magnetic fluxes flowing circularly around them, and magnetic fluxes that flow circularly around the two adjacent transmission line conductors take place where the two adjacent transmission line conductors are closely stacked.

As a result, by narrowing the spacing between two adjacent transmission line conductors, the coupling between the two adjacent transmission line conductors is increased and a desired characteristic impedance is easily obtained. Even if the transmission line is disposed between the two ground electrodes to be a strip-line structure, a drop in characteristic impedance of the transmission line arising from the effect of stray capacity generated between the transmission line and the ground electrodes is compensated for, and a high characteristic impedance of the transmission line is provided. Compared with the conventional art, the Q factor of the strip-line resonator is heightened as shown in FIG. 3 (the solid line: this embodiment, the dotted line: conventional art).

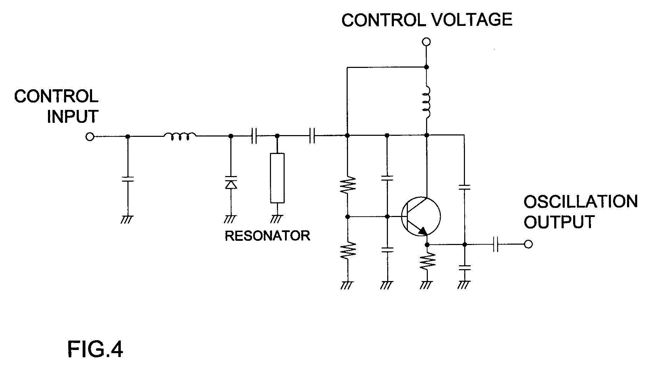

To compared the strip-line resonator 10 of this embodiment (FIG. 1) with the conventional strip-line resonator 50 (FIG. 5), experiments are conducted to measure C/N using the resonator in a voltage-controlled oscillator shown in FIG. 4, and the experiment show improvements that C/N of the strip-line resonator 10 of this embodiment is -106 (cBc/Hz) while C/N of the conventional strip-line resonator 50 is -100 (dBc/Hz). This is because the Q factor of the strip-line resonator is high.

The above embodiment is one example of the strip-line resonator shown in FIGS. 1 and 2, and any strip-line resonator will fall within the scope of the present invention if its transmission line has a plurality of transmission line conductors which generally face one another in the direction of lamination of the laminated body with a dielectric layer therebetween and are electrically connected in series so that high-frequency signals on two adjacent transmission line conductors of the plurality of transmission line conductors travel in the same direction.

In the above embodiment, the transmission line conductors have a semi-spiral configuration, and depending on the specifications about an available area and a desired characteristic impedance, the transmission line conductors may have a spiral configuration, a meandering configuration or a combination of both.

FIG. 5 is a schematic diagram of a second embodiment of the variable resonator of the present invention. Referring to FIG. 5, the variable resonator 110 comprises an input terminal 101, first and second ports P1 and P2, capacitors C11∼C15, resistors R11, R12, a variable capacitance diode CV11, and a resonator L11. The variable resonator 110, for example, constitutes a variable resonator X of a voltage-controlled oscillator shown in FIG. 10. The FIG. 10 shows a circuit arrangement of a voltage-controlled oscillator that is conventionally and widely used in a variety of radio equipment including mobile communications equipment such as a car phone and a portable telephone. There are shown an input terminal 51, an output terminal 52, a power supply input terminal 53, a operating power supply voltage Vcc, capacitors C51∼ C60, resistors R51∼R54, transistors Q51∼Q52, a variable capacitance diode CV51, a resonator L51, and inductors L52 and L53. A variable resonator X is constituted by the capacitors C51∼C53, the variable capacitance diode CV51, the resonator L51 and the inductor L52, and an active oscillator Y is constituted by capacitors C54∼C60, resistors R51∼R54, transistors Q51, Q52, and the inductor L53.

When an input voltage VT applied to the input terminal 51 changes in the variable resonator X, the capacitance of the variable capacitance diode CV51 changes. The oscillation frequency is determined by the capacitance of the variable capacitance diode CV51 variably set by the input voltage VT and capacitance of the capacitors C52∼C53, and the resonator L51.

FIG. 6 is a perspective view of the variable resonator 110 shown in FIG. 5. The variable resonator 110 includes a substrate 111 which is a lamination of a plurality of dielectric layers (not shown), and has, on one principal surface of the substrate 111, the variable capacitance diode CV11, the capacitance of which changes in response to an input voltage, and passive components including a capacitor C1 and resistors R1 and R2.

Disposed within the substrate 111 are the resonator L11, and capacitors C12∼C15 as passive components, though they are not shown. Formed on the other principal surface and side surfaces of the resonator L11 are terminals T1∼T8 such as interconnect terminals for connection with external components, an input terminal for receiving an input voltage, and a ground terminal for grounding.

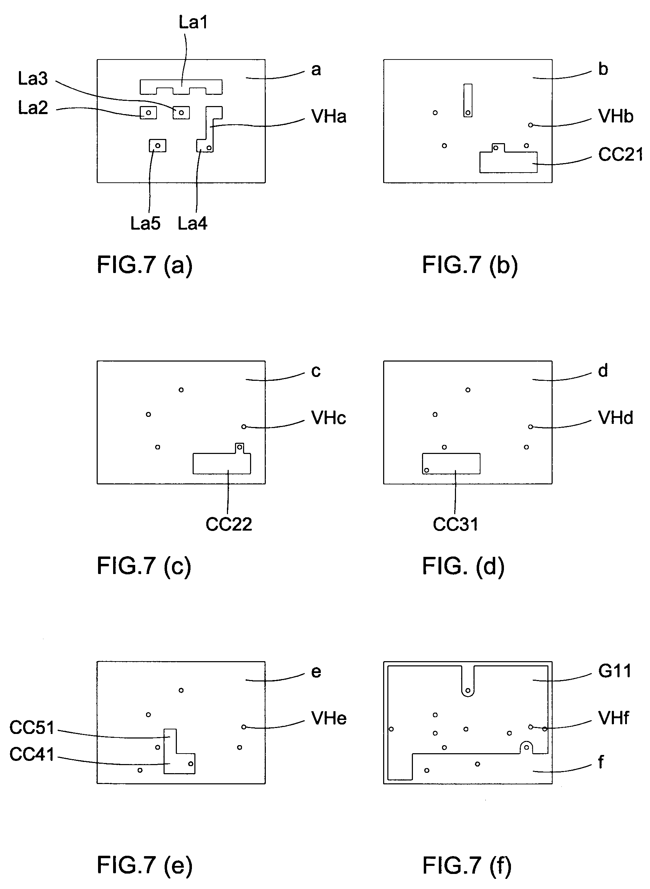

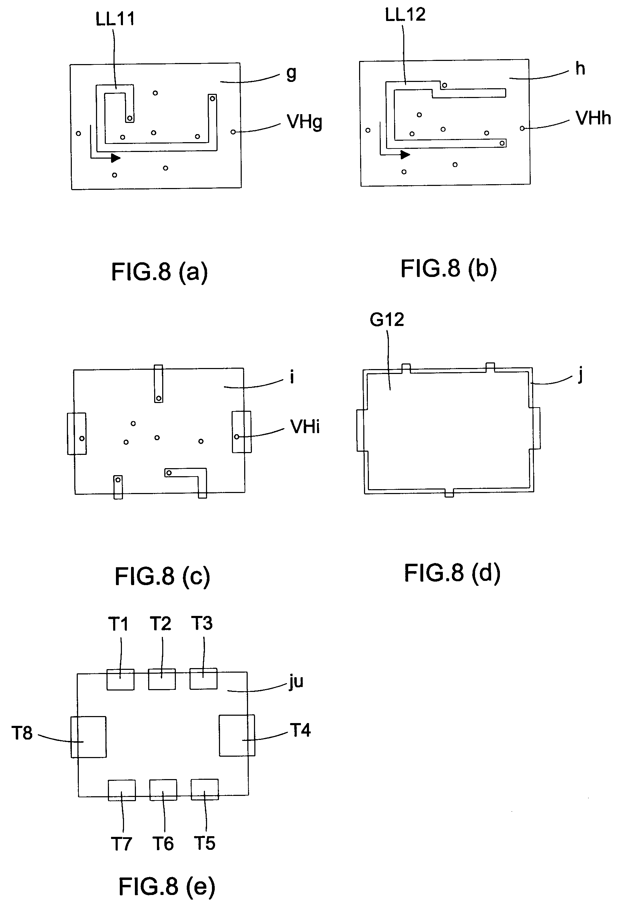

FIGS. 7(a)∼ 7(f) and FIGS. 8(a)∼8(d) are respectively top views and bottom views of dielectric layers constituting the substrate 111 of the variable resonator 110 of FIG. 6. The resonator L11 and capacitors C12∼C15, constituting the variable resonator 110, are contained in the substrate 111 and the substrate 111 is produced by laminating a first ∼ tenth dielectric layers a ∼ j from top to bottom, each constructed of low-temperature fired ceramic containing barium oxide, aluminum oxide, silica as its main components, which can be fired at a temperature range of 850°C ∼ 1000°C.

Formed on the first dielectric layer a are lands La1∼La5 for mounting the variable capacitance diode CV11, the capacitor C11 and the resistors R11, R12. Respectively formed on the second ∼ fifth dielectric layers b∼e are capacitor electrodes CC21, CC22, CC31, CC41, and CC51.

Formed on the seventh and eighth dielectric layers g, h are transmission line conductors LL11 and LL12 constituting a transmission line L11. Respectively formed on the sixth and tenth dielectric layers f, j are ground electrodes G11, G12. Formed on the underside of the ninth dielectric layer i (denoted by reference character ju in FIG. 8(e)) are the input terminal 101, the first and second port P1, P2 and external terminals T1∼T8 serving as ground terminals.

The first ∼ tenth dielectric layers a∼j have via holes VHa∼VHi and signal line electrodes (not shown) in required locations, and by way of the via holes VHa∼VHi, the capacitor electrodes CC21, CC22, CC31, CC41, CC51, the transmission line conductors LL11, LL12, the ground electrodes G11, G12, and the external terminals T1∼T8 are properly interconnected.

The capacitors C12∼C15 of the variable resonator 110 are constructed between capacitor electrode CC21 and the capacitor electrode CC22, and between each of the capacitor electrodes CC31, CC41 and CC51 and the ground electrode G11, respectively.

The resonator L11 is constructed of the transmission line constituted by the transmission line conductors LL11, LL12, and the ground electrodes G11, G12 disposed above and below them.

The substrate 111 containing the resonator L11 and the capacitors C12∼C15, constituting the variable resonator 110 shown in FIG. 1, is thus constructed. The variable resonator 110 is constructed by mounting, on one principal surface of the substrate 111, the variable capacitance diode CV11, the capacitor C11, and the resistors R11, R12, constituting the variable resonator 10 shown in FIG. 5.

The transmission line conductors LL11, LL12 constituting the resonator L11 are sandwiched between the sixth dielectric layer f and eighth dielectric layer h constituting the substrate 111, and are consequently sealed with the insulating supports.

The capacitor C11 may be formed within the substrate in the same manner as the capacitors C12∼C15. The resistors R11, R12 may be formed on the principal surface of the substrate or within the substrate as a printed resistor.

As described above, since in the variable resonator of the present invention, circuit components constituting the variable resonator, for example, the resonator, the variable capacitance diode, capacitors and resistors are built into or mounted on the substrate which is a lamination of a plurality of dielectric layers, compact design is implemented in the variable resonator. As a result, the radio equipment incorporating the variable resonator is made compact accordingly.

The transmission line of the resonator in the variable resonator is constructed of a plurality of layers of transmission line conductors and the directions of travel of high-frequency signals propagating on two adjacent transmission line conductors with a dielectric layer placed therebetween are the same; thus, the directions of flows of the magnetic fluxes generated circularly around the transmission line conductors are the same. Therefore, by narrowing the spacing between two adjacent transmission line conductors, the coupling between the transmission line conductors of the resonator is increased.

As a result, by narrowing the spacing between two adjacent transmission line conductors, the coupling between the transmission line conductors of the resonator is increased and a desired characteristic impedance is easily obtained. Even if the transmission line is disposed between the two ground electrodes to be a strip-line structure, a drop in characteristic impedance of the transmission line arising from the effect of stray capacity generated between the transmission line and the ground electrodes is compensated for, and a high characteristic impedance of the transmission line is provided. The Q factor of the resonator is thus heightened.

By building the resonator into the substrate that is a lamination of a plurality of dielectric layers, the resonator is of a monolithic structure supported by the insulating supports, and is thus electrically insulated from outside.

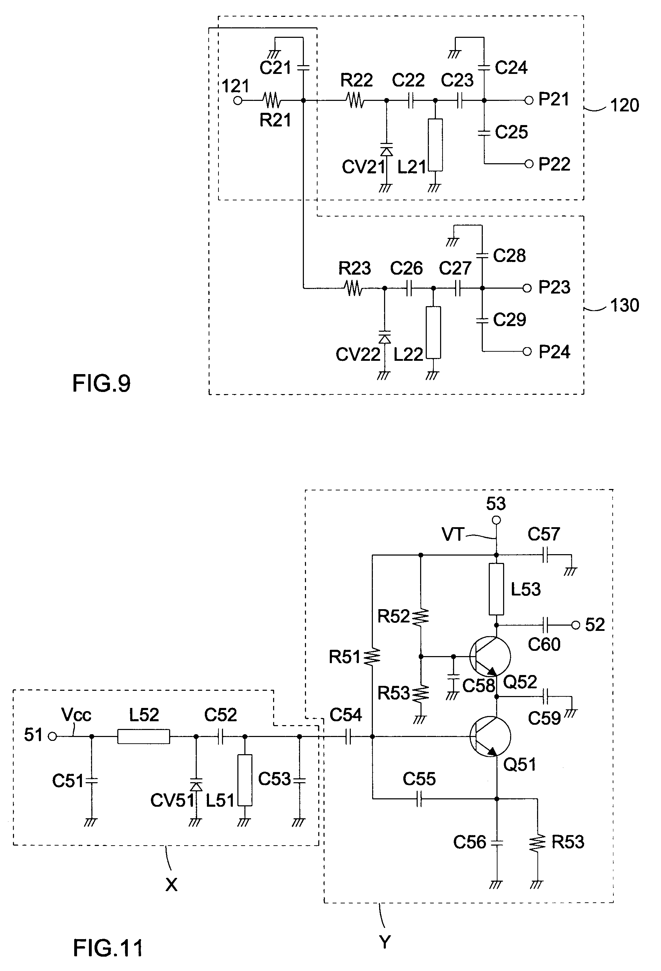

As shown in FIG. 9, two variable resonators 120, 130 comprising an input terminal 121, a first ∼ fourth ports P21∼P24, capacitors C21∼C29, resistors R21∼R23, variable capacitance diodes CV21, CV22, resonators L21, L22 may be integrated into a single substrate with the input terminal 121, capacitor C21 and resistor R21 common to both variable resonators. In this case, if one variable resonator 120 is connected to a transmitter side voltage-controlled oscillator with the other variable resonator 130 connected to a receiver side voltage-controlled oscillator, the radio equipment having these mounted thereon is made even more compact.

The transmission line constituting the resonator of the variable resonator shown in FIGS. 7 and 8 is one example and any resonator will fall within the scope of the present invention if its transmission line has a plurality of transmission line conductors which generally face one another in the direction of lamination of the laminated body with a dielectric layer therebetween and are electrically connected in series so that high-frequency signals on two adjacent transmission line conductors of the plurality of transmission line conductors travel in the same direction.

In the above discussion, the transmission line conductors have a semi-spiral configuration, and depending on the specifications about an available area and a desired characteristic impedance, the transmission line conductors may have a spiral configuration, a meandering configuration or a combination of both.

While the invention has been particularly shown and described with reference to preferred embodiments thereof, it will be understood by those skilled man in the art that the forgoing and other changes in form and details may be made therein without departing from the spirit of the invention.

## Claims

1. A strip-line resonator (10), comprising:
a laminated body including a plurality of dielectric layers (13a - 13e) laminated to each other;
a plurality of transmission line conductors (11a, 11b) disposed between said dielectric layers (13b, 13c, 13d) respectively, in which at least two of said transmission line conductors (11a, 11b) are substantially opposed to each other via said dielectric layer (13c) and electrically connected in series so that high-frequency signals traveling on said transmission line conductors (11a, 11b) travel in the same direction; and
a ground conductor (14) disposed between said dielectric layers (13a, 13b, 13d, 13e), opposed to said transmission line conductor (11a, 11b) via said dielectric layer (13b, 13d), and electrically disconnected to said transmission line conductor (11a, 11b).

2. A variable resonator (110) including the strip-line resonator (10) of claim 1, comprising:
a substrate (111) including said strip-line resonator (10);
a variable capacitance diode (CV 11) mounted on said substrate (111);
a passive component (C11, R11, R12) disposed within or mounted on the substrate (111); and
an external terminal (T1 - T8) provided on the surface of the substrate.
